# EUROPEAN PATENT APPLICATION

(11) **EP 1 447 847 A2**
(43) Date of publication of application: **18.08.2004**
(21) Application number: 04250482.9
(22) Date of filing: 29.01.2004
(51) Int. Cl.: H01L 23/495

(54) **Lead frame for an electronic component package**

(30) Priority: 13.02.2003 GB 0303285
(71) Applicant: Atlantic Technology (UK) Ltd., Croespenmaen, Crumlin, NP11 3XT (GB)
(72) Inventor: Rae, Angus, Newport South Wales, NP10 9LD (GB); Protheroe, Robert Rhys, Caerphilly Borough, South Wales CF82 7AZ (GB)
(74) Representative: Evans, Huw David Duncan

(57) **Abstract**

A lead frame 10 for use in a leadless package such as a quad flat non-leaded package (QFN), comprises an array of sites 11 for receiving respective electronic component devices 15 on the upper surface of the frame 10 and a plurality of rails 12 arranged in a grid, with each site 11 being disposed in a respective region within the grid. The rails 12 carry lead-fingers 14 which project into respective sites 11 and the lower surface of the frame 10 is partially etched over regions R1, R2 extending along lateral edges of the rails 12 from which the lead-fingers extend, the partially etched regions R1, R2 extending partially into the lead-fingers.

An unetched region M extends along each rail 12 and acts to strengthen the rails 12 and thus prevents the rails 12 from flexing unduly under the applied pressure during wire bonding of the component 15.

## Description

This invention relates to the packaging of electronic components and more particularly but not solely to the packaging of semiconductor components.

Traditional electronic components comprise a body which houses the active or passive electronic device and a plurality of projecting leads for connecting the device to relevant terminals on a printed circuit board.

Nowadays there is a requirement to substantially reduce the size of electronic components so as to make smaller and denser electronic circuits. This resulted in the creation of so-called surface-mount components and more recently, quad flat non-leaded component packages (QFN), in which the projecting leads are replaced by conductive pads formed on the underside of the body of the component. It will be appreciated that the lack of projecting leads reduces the overall size of the component.

Leadless electronic components are formed by die bonding the component device on a die pad of a metal lead-frame and then connecting the device with wire to terminals formed integrally on the frame by a process known as wire bonding. The upper surface of the lead-frame is then encapsulated to form a solid block that protects the device and wires, and has the conductive terminals exposed on its underside.

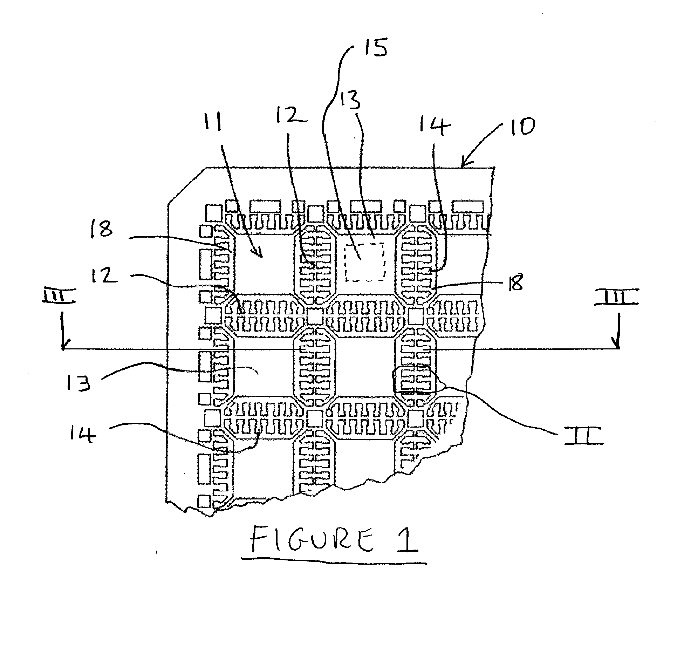

Referring to Figures 1 to 3 of the drawings, a typical lead-frame assembly for a quad flat non-leaded package (QFN) comprises a one-piece lead-frame 10 formed of a sheet of copper having an array of sites 11 for respectively receiving the individual component devices 15. A grid of rails 12 is formed on the lead-frame 10, with each site 11 occupying one space within the grid. Each site 11 comprises a central die pad 13 surrounded on its four sides by radially extending terminals or so-called lead-fingers 14, which are solely connected to the rails 12 of the lead-frame 10 at their radially outer ends.

The individual component devices 15 are die-bonded to the upper surface of the die pads 13 of respective sites 11 and then the contact pads on the devices 15 are wired to respective lead-fingers 14 of the site 11 by a thermosonic bonding apparatus, which is programmed to bond one end of a fine wire 16 to a conductive pad on the component device 15 and then to draw the wire 16 out through a ceramic capillary to a lead-finger 14 on the lead-frame 10, where it is again bonded. This process is then repeated for each connection to be made between the conductive pads on the component device 15 and the lead-fingers 14 of the lead-frame 10.

The upper surface of the assembly is then encapsulated in block of resin 17, which extends through the openings 18 in the lead-frame 10 and comprises an undersurface lying in the same plane as the undersurface of the lead-frame 10.

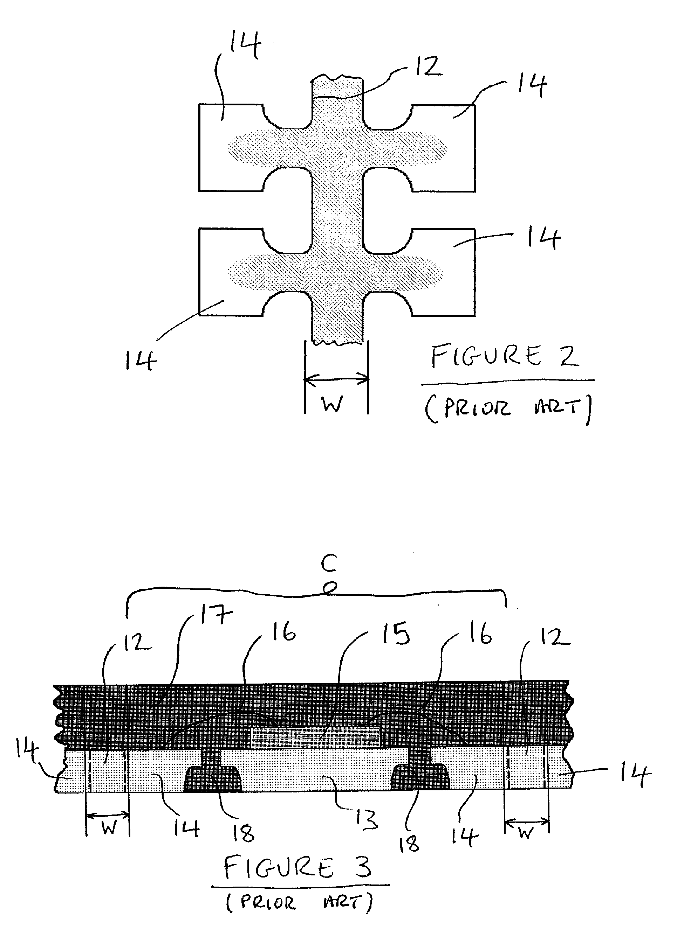

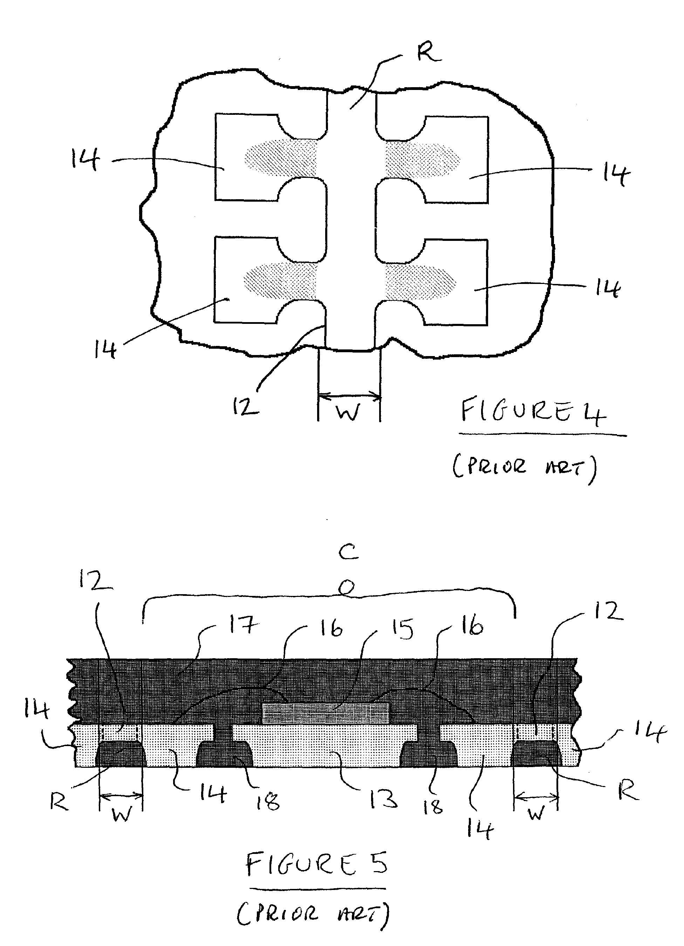

Following encapsulation, the lead-frame assembly is singulated to form individual electronic components C by cutting along the rails 12 using a saw of a width W which is slightly wider than the width of the rails 12, as shown in Figures 2 and 3. In this manner, the adjacent lead-fingers 14 of each singulated component C are electrically isolated from each other.

A disadvantage of the aforementioned method of singulation is that the saw causes undesirable burrs along the cut edges of the lead-fingers 14.

Referring to Figures 4 and 5 of the drawings, it has been proposed to overcome this problem by half-etching the underside of the provided lead-frame 10 to reduce the thickness of the lead-frame 10 in a region R which extends along the rails 12 and partially into the lead-fingers 14. In this manner, the edges of the saw cut through partially etched regions at the points where the lead-fingers 14 meet the rails 12. These partially etched regions R are bounded on both their upper and lower sides by the resin encapsulation material 17 and thus burring of the cut lead-fingers 14 is avoided. Another advantage of half-etching the underside of the provided lead-frame 10 is that the saw is less prone to wear, since it has to cut through less metal.

A disadvantage of the above-mentioned solution to the problem of burring is that it substantially weakens the rails 12, with the result that difficulties are encountered when wire bonding the connecting wires 16 to the lead-fingers 14: The pressure with which the wire 16 is bonded to the lead-fingers 14 is crucial, since an over pressure can damage the lead-fingers 14 and an under pressure can result in an unsatisfactory bond. Furthermore, the thermal and electrical conductivity of the lead-fingers 14 and the supporting rails 12 affects the reliability of the bond.

Accordingly, because the rails 12 are weak and have a tendency to flex under the applied pressure, the bond parameters of the apparatus are difficult and time consuming to set up and can vary greatly between each lead-frame.

We have now devised a lead-frame for use in manufacturing an electronic component, which lead-frame alleviates the above-mentioned problems.

In accordance with this invention, there is provided a lead-frame formed of a sheet of metal, the lead-frame comprising an array of sites for receiving respective electronic component devices on the upper surface of the frame, a plurality of rails arranged in a grid, with each site being disposed in respective regions within of the grid, at least some of the rails carrying lead-fingers which project into respective sites, wherein the lower surface of the frame is partially etched over regions disposed at the points where the lead-fingers meet the rails, a strengthening region extending medially along each rail and having a thickness which is greater than the thickness of the partially etched regions.

Following encapsulation, the lead-frame assembly is singulated to form individual electronic components by cutting along the rails using a saw which is slightly wider than the width of the rails. In this manner, the edges of the saw cut through partially etched regions at the points where the lead-fingers meet the rails. These partially etched regions are bounded on both their upper and lower sides by the resin encapsulation material and thus burring of the cut lead-fingers is avoided: Burring only occurs if you cut through an area of full thickness copper. When it is half etched, the edge that would burr is surrounded by the resin encapsulation material, which stops the burr occurring as the exit of the saw blade from the component is through compound and not copper.

The strengthening region extending medially along each rail strengthens the rail and thus prevent the rail from flexing unduly under the applied pressure during wire bonding. The bond parameters of the apparatus are therefore not as difficult and time consuming to set up.

Preferably the strengthening region on each rail is unetched.

Preferably, the lower surface of the lead-frame is partially etched over regions extending along lateral edges of the rails from which the lead-fingers extend, said partially etched regions extending partially into the lead-fingers.

An advantage of half-etching the underside of the lateral side edges of the rails is that the saw is less prone to wear, since the saw has to cut through less metal as it passes along the rails.

Preferably, lead-fingers are provided on opposite sides of rails bounding adjacent sites, said bounding rails being partially etched along opposite lateral side edges, an unetched medial portion extending longitudinally along said bounding rails.

An embodiment of the invention will now be described by way of an example only and with reference to the accompanying drawings, in which:
Figure 1 is a bottom view of a conventional lead-frame;
Figure 2 is an enlarged view of a portion of the lead-frame of Figure 1;
Figure 3 is a sectional view along the line III-III of the lead-frame of Figure 1, when assembled;
Figure 4 is an enlarged view of a portion of a conventional partially etched lead-frame;
Figure 5 is a similar view to the view of Figure 3 through a lead frame assembly incorporating the conventional partially etched lead-frame of Figure 4;
Figure 6 is an enlarged view of a portion of a lead-frame in accordance with this invention;
Figure 7 is a similar view to the view of Figure 3 through a lead frame assembly incorporating the lead-frame of Figure 6.

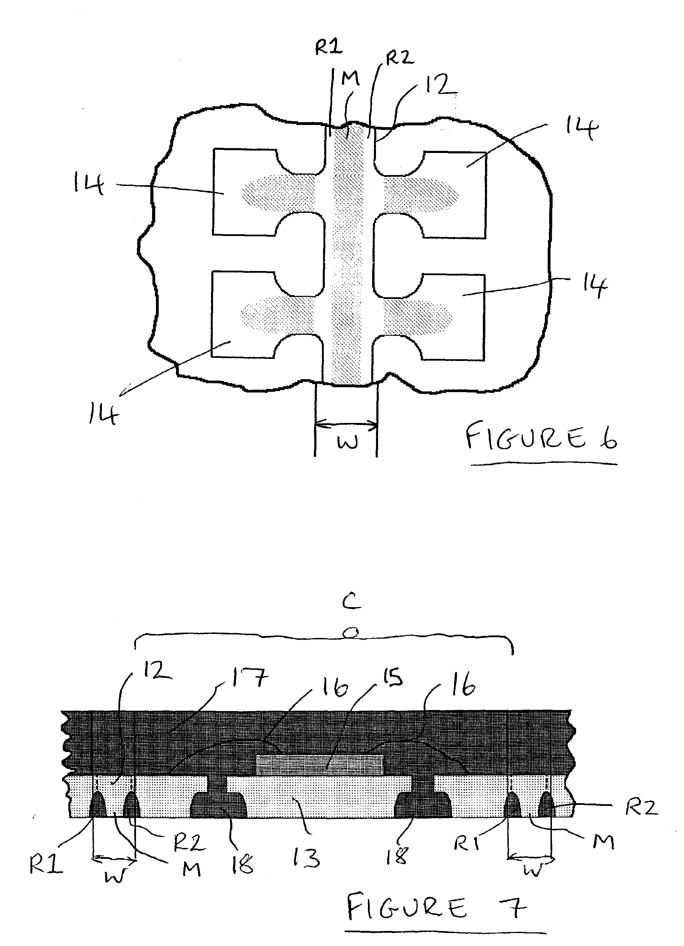

Referring to Figures 6 and 7 of the drawings, there is shown a lead-frame which is substantially similar in construction to the lead-frame of Figures 1 to 5 and like parts are given like reference numerals.

The underside of the rails 12 carrying lead-fingers 14 are partially etched in regions R1, R2 extending along their lateral side edges, with the partially etched regions R1, R2 extending partially into the lead-fingers 14.

The unetched medial portion M of the partially etched rails 12 has an undersurface which lies in the same plane as the undersurface of the lead-frame 10, as represented by the shading in Figure 6.

The unetched medial portion M extending along each rail acts to strengthen the rail and thus prevents the rail from flexing unduly under the applied pressure during wire bonding. The bond parameters of the apparatus are therefore not as difficult and time consuming to set up as conventional partially etched lead-frames.

## Claims

1. A lead-frame formed of a sheet of metal, the lead-frame comprising an array of sites for receiving respective electronic component devices on the upper surface of the frame, a plurality of rails arranged in a grid, with each site being disposed in a respective region within the grid, at least some of the rails carrying lead-fingers which project into respective sites, the lower surface of the frame being partially etched over regions disposed at the points where the lead-fingers meet the rails, **characterised in that** a strengthening region, having a thickness which is greater than the thickness of the partially etched regions, extends medially along each rail.

2. A lead-frame as claimed in claim 1, **characterised in that** the strengthening region on each rail is unetched.

3. A lead-frame as claimed in claims 1 or 2, **characterised in that** the lower surface of the lead-frame is partially etched over regions extending along lateral edges of the rails from which the lead-fingers extend, said partially etched regions extending partially into the lead-fingers.

4. A lead-frame as claimed in any preceding claim, **characterised in that** lead-fingers are provided on opposite sides of rails bounding adjacent sites, said bounding rails being partially etched along opposite lateral side edges, an unetched medial portion extending longitudinally along said bounding rails.
